# EUROPEAN PATENT SPECIFICATION

(11) **EP 1 996 744 B1**
(45) Date of publication and mention of the grant of the patent: **23.02.2011**
(21) Application number: 07762413.8
(22) Date of filing: 19.01.2007
(51) Int. Cl.: C23C 14/24, C23C 14/00, C23C 14/06, C23C 14/16, C23C 14/18, C23C 14/20, C23C 14/32

(54) **ANTIMICROBIAL COATING METHODS**
VERFAHREN ZUR ANTIMIKROBIELLEN BESCHICHTUNG
PROCEDES DE REVETEMENT ANTIMICROBIEN

(30) Priority: 27.01.2006 US 762769 P; 30.01.2006 US 763262 P; 25.02.2006 US 776537 P; 06.03.2006 US 779917 P
(43) Date of publication of application: 03.12.2008
(73) Proprietor: NanoSurface Technologies, LLC, Maple Grove MN 55369 (US)
(72) Inventor: STOREY, Daniel, M., Minneapolis, MN 55414 (US); SEWELL, Deidre, Fort Collins, CO 80526 (US); PETERSON, John, H., Longmont, CO 80501 (US); MCGRATH, Terrence, S., Longmont, CO 80503 (US)
(74) Representative: Zwicker, Jörk
(86) International application number: PCT/US2007/001695
(87) International publication number: WO 2007/087269

(56) References cited:
- EP-A- 0 658 634
- WO-A-95/13704
- WO-A-03/044240
- WO-A-2004/059027
- US-A- 5 753 251
- US-A- 6 103 074
- US-B1- 6 333 093
- VYSKOCIL J ET AL: "CATHODIC ARC EVAPORATION IN THIN FILM TECHNOLOGY*" JOURNAL OF VACUUM SCIENCE AND TECHNOLOGY: PART A, AVS /AIP, MELVILLE, NY.; US, vol. 10, no. 4 PT II, 1 July 1992 (1992-07-01), pages 1740-1748, XP000296235 ISSN: 0734-2101

## Description

This application claims benefit of U.S. Provisional Application Serial No. 60/762,769 filed January 27, 2006, U.S. Provisional Application Serial No. 60/763,262 filed January 30, 2006, U.S. Provisional Application Serial No. 60/776,537 filed Feb. 25, 2006 and U.S. Provisional Application Serial No. 60/779,917 filed March 6, 2006, the disclosures of which are incorporated by reference. This application is a continuation-in-part application of U.S. Patent Application Serial No. 10/741,015 filed Dec. 18, 2003 which claims benefit of U.S. Provisional Application Ser. No. 60/434,784, filed Dec. 18, 2002.

FIELD OF THE INVENTION

The invention relates to cathodic arc ion plasma deposition methods for preparing modified metal coatings useful for forming an anti-microbial surface on devices and materials used in medical applications. In particular, the invention relates to a process for depositing silver (Ag), and other anti-microbial metals, or combinations thereof under highly controlled conditions to form antimicrobial coatings that have improved adhesion and maintain activity over extended periods of time.

BACKGROUND

The germicidal properties of metals such as silver, zinc, niobium, tantalum, hafnium, zirconium, titanium, chromium, nickel, copper, platinum and gold are well documented. Of these metals, silver, in the form of ions or compounds, is probably the best known and most widely used anti-microbial metal. Elemental silver has some anti-microbial benefit, but is generally too unreactive for most anti-microbial applications. An oxidized form of silver is considered to be more active as an anti-microbial as indicated by the observation that painting and inking of silver oxides leads to a decrease in their reactivity and solubility.

Attempts have been made to improve the reactivity of silver through the use of silver oxides and combinations of silver with other materials using accepted methods of solution-based chemistry. U.S. Pat. No. 4,828,832 describes the use of metallic silver salt solutions such as aqueous silver nitrate in combination with an oxidizing agent, such as benzoyl peroxide, to treat skin infections.

U.S. Pat. No. 5,824,267 discloses imbedding the surface of a plastic article with silver metal particles and ceramic or base metal particles to impart antibacterial properties to the plastic article. The extremely fine silver metal particles are obtained by chemical deposition from an aqueous silver salt solution.

Although solution methods of generating silver particles are able to provide anti-microbially active silver, there is little control over the structure of the resulting silver particles, so that these methods are limited in their applications. Moreover, some ionic species, such as aqueous silver nitrate, are too reactive for most applications because of the potential for skin irritation and must therefore be carefully monitored and controlled. Another problem with solution-based chemistry is the development of stable combinations without generating harmful byproducts. Silver ions bound in solutions of pastes, paints, polymers or gels tend to have a short shelf life, in part because of the side reactions with various constituents that can occur in water-based solutions.

There is a distinct need for anti-microbial surfaces that are capable of generating a sustained release of anti-microbial metal ions. The ability of a surface to generate a sustained release of anti-microbial ions would be particularly useful in surgical and wound dressings and bandages, surgical sutures, catheters and other medical devices, implants, prosthetics, dental applications and tissue regeneration. Other devices that would also benefit from a sustained release of anti-microbial materials include medical tools and surfaces, restaurant surfaces, face masks, clothing, door knobs and other fixtures, swimming pools, hot tubs, drinking water filters, cooling systems, porous hydrophilic materials, humidifiers and air handling systems.

A method for generating a sustained release of metallic ions is described in U.S. Pat. No. 4,886,505. According to the method, a device is coated with a first metal, such as silver, and a second metal, such as platinum, which is connected to the first metal through a switch. The presence of the silver and platinum metals in the presence of body fluids results in a galvanic action which is intended to release or liberate silver ions. The release of ions is controlled by the switch, which is operated external to the device.

The technique of applying a current to a silver-coated wound dressing or medical device is also the subject matter of U.S. Pat. Nos. 4,219,125 and 4,411,648. Although the use of external switch controls or an external electric current can enhance the rate of metal ion release, such external controls or currents-may not be practical for a variety of applications.

U.S. Pat. No. 6,365,220 describes a process for producing an anti-microbial surface that provides a sustained release of anti-microbial ions without the need for an external electric current to maintain the release. According to the disclosure, multiple layers of metallic thin films are deposited on a substrate using a sputtering or evaporation process. By using different metal combinations for the different layers, and employing etching techniques to roughen or texture the surface of the layers, multiple microlayer interfaces can be generated. The multiple interfaces, when exposed to body fluids, provide for release of ions by galvanic and non-galvanic action.

U.S. Pat. No. 5,837,275 also discloses anti-microbial coatings that provide a sustained release of anti-microbial ions. Coatings are prepared by a sputter technique using specific deposition parameters. The coatings are described as metal films exhibiting "atomic disorder" which is claimed to be required for sustained release of metallic ions.

Single ordered crystals of tetrasilver tetroxide (Ag₄O₄) are claimed to be useful as an anti-microbial in treating skin diseases (U.S. Pat. No. 6,258,385.) Such a composition, however, is not practical for other than topical use, and its ability to provide a sustained release of anti-microbial materials over a long period of time *(i.e*., several days) without reapplication, has not been demonstrated.

Deposition of anti-microbial materials is commonly limited to one of three distinct methods for producing silver and silver oxide coatings. Each of these methods has serious disadvantages and none have been developed to efficiently produce highly adherent, evenly distributed anti-microbial films on surfaces of medical devices and instruments. Commonly used state of the art processes, such as sputtering, dip and Ion Beam Assisted Deposition, produce coatings with limited adhesion to flexible substrates or elastic devices. Additional layers to increase adhesion are sometimes necessary at a significant cost in processing time.

Deposition of metal materials on a substrate by cathodic arc in a vacuum is known in the art. In contrast to other plasma vapor deposition methods, ion plasma deposition (IPD) can produce dense multi-component coatings of high purity as described in U.S. Patent Application Pub. No. 2004/0185182. However, conventional cathodic arc deposition methods suffer from certain disadvantages. A waste of expensive material can occur due to inefficient use of the target material and the lack of particle control. The lack of control over the material being deposited can result in the formation of particles of varying sizes, which leads to the deposition of non-uniform coatings. Typically, the cathodic arc processes also require the substrate surface to be heated to very high temperatures, which can damage the substrate material and severely restrict the choice of substrates.

WO 03/044240 refers to a process and apparatus for depositing thin films onto the surface of a substrate using cathodic arc deposition.

WO 04/059027 A2 refers to a process for depositing anti-microbial materials into or onto the surface of a substrate using ionic plasma deposition. The process includes the step of providing a cathode target material having anti-microbial potential which is disposed within a partial vacuum, powering the cathode to generate the plasma discharge for ionizing the target material into a plasma of constituent particles.

### BRIEF SUMMARY OF THE INVENTION

The present invention addresses the continuing need for anti-microbial materials that will adhere to any surface, have controlled release rates and longevity, and are nontoxic in a desired application. Anti-microbial coatings with these characteristics can be deposited on a wide range of substrate surfaces using the novel cathodic arc IPD deposition process, herein described.

It is an object of the present invention to provide a method of depositing anti-microbial materials onto a substrate by using an ionic plasma deposition process to form discrete layers of anti-microbial particles.

A further object of the invention is to provide a method for producing anti-microbial surfaces on any finished product, thus eliminating the need to employ complex chemistry, pasting, printing and bonding technologies.

Another object of the invention is to provide an anti-microbial surface that provides a sustained release of an anti-microbial agent *in vivo* at therapeutically effective levels for extended periods of time.

Another object of the invention is to provide an anti-microbial surface by impregnating or depositing dispersed metals and/or metal/metal oxides of one or more elements into a substrate for the sustained release of metal ions.

Accordingly, in particularly preferred embodiments, the present invention provides the deposition, impregnation or layering of silver or other metal ions bound into solid state structures of nano-, pico-, and micro-sized crystalline metal and metal oxide compounds which can be designed as combinations of mono-, di-, and polyvalent oxides dispersed into or onto a surface. The silver ions will then be released by contact with pathogens due to enzyme activity or released by the addition of water or contact with body fluids.

The disclosed process is useful for the manufacture of a wide variety of devices which require a controlled composition, but is particularly useful in the manufacture of small to very large area rolls, such as bandages, or individual parts, such as catheters, stems or implants, that require a germicidal, bactericidal, biocidal or antimicrobial surface. The process results in the control of the amount, particle size and energy of ionized material to be combined with ionized oxygen or other gases, and is applicable to a wide range of monovalent, divalent, and polyvalent oxides and nitrides and combinations of layers.

The process can be used to make anti-microbial products or to surface treat existing products and raw materials. The process can be used concurrently to create small scale energy devices to enhance anti-microbial activity or to power other nano-technology devices; for example, silver oxide batteries to power micropumps, implants, galvanic surfaces and other devices needing power.

Accordingly, one aspect of the invention is to provide a process for depositing an anti-microbial surface on a substrate which comprises the steps of placing a cathode target comprising a potential anti-microbial metal into an evacuated chamber and powering the cathode to generate an arc at the cathode which ionizes the cathode metal into a plasma of ionized particles; introducing a reactive gas, such as oxygen, into the vacuum chamber such that the gas reacts with the ionized plasma particles, and controlling deposition of the plasma particles on the substrate by moving the substrate closer or further from the target in a controlled manner during the deposition process.

Further control of the deposition process may be achieved by an arc control means whereby the power supply to the cathode is adjusted to alter the speed of arc production.

An additional aspect of the invention is to provide on a substrate, an anti-microbial surface comprising a dispersion of metal oxide particles, wherein the metal is selected from the group consisting of silver, nickel, zinc, copper, gold, platinum, niobium, tantalum, hafnium, zirconium, titanium, chromium, and combinations thereof.

The present invention relates to a process of depositing anti-microbial materials onto a selected substrate material. The substrate can be of any material, such as metal, ceramic, plastic, glass, flexible sheets, porous papers, ceramics or combinations thereof. Although the substrate can comprise any of a number of devices, medical devices are particularly preferred. Such medical devices include catheters, implants, stents, tracheal tubes, orthopedic pins, shunts, drains, prosthetic devices, dental implants, dressings and wound closures. However, it should be understood that the invention is not limited to such devices and may extend to other devices useful in the medical field, such as face masks, clothing, surgical tools and surfaces.

There are two important factors regarding implant infection: the introduction of bacteria during implant surgery; and, transdermal openings following surgery. Transdermal devices are a prime location for infections. As the device separates from the skin, a fissure forms between the skin and device, allowing bacterial contamination.

This invention, in further aspects, is related to improved and more economical methods for providing tuned anti-microbial surfaces or other components on medical devices for use in the human body as well as in veterinary and other applications.

Anti-microbial material can be any solid material or combination of materials having anti-microbial properties. Preferred materials are metals having potential anti-microbial properties and which are biocompatible *(i.e*., not damaging in the intended environment). Such metals include silver, zinc, niobium, tantalum, hafnium, zirconium, titanium, chromium, nickel, copper, platinum and gold (also referred to herein as "anti-microbial metals"). The term "potential anti-microbial properties" is meant to recognize the fact that these metals, in their elemental state, are typically too unreactive to act as effective anti-microbials. However, there is a much stronger anti-microbial effect when the metals are ionized. Thus, the anti-microbial metals have potential anti-microbial properties, which are realized upon ionization of the metals. When ionized, the anti-microbial metals can also be combined with various reactive gases, for example, nitrogen or oxygen to form compounds of nitrides, oxides, and/or combinations thereof.

DEFINITIONS

Ionic Plasma Deposition (IPD) is a method of creating highly energized plasma by using a cathodic arc discharge on a target material.

Cathodic arc, also known as a vacuum arc, is a device for creating a plasma from solid metal. An arc is struck on the metal, and the arc's high power density vaporizes and ionizes the metal, creating a plasma which sustains the arc. A vacuum arc is different from a high-pressure arc because the metal vapor itself is ionized, rather than an ambient gas.

Macros or macroparticles are particles larger than a single ion; nano (or small) particles are particles about 100 nanometers in size; medium macro particles are 100 nanometers to about 1 micron; large macro particles are particles larger than 1 micron.

Coulomb explosion occurs when a sufficiently intense power source disrupts a group of atoms such as a gas cluster, object, or target so that the electric field of the power source drives some or all of the electrons off the atoms. Without electrons, the group of ions explodes due to the Coulombic repulsion of the positive charges.

Plasma vapor deposition (PVD) is a thin film deposition process in the gas phase in which source material is physically transferred in the vacuum to the substrate without any chemical reaction involved. This type of deposition includes thermal evaporation electron-beam deposition and sputtering deposition. The IPD process is a subtype of physical vapor deposition.

The term "medical device" as used herein is intended to extend broadly to all devices used in the medical field, including stents, catheters, various implants and the like regardless of the material from which it is fabricated. References herein to medical devices and other medical references are understood to also include veterinary devices and applications.

The term "potential anti-microbial properties" is meant to recognize the fact that some metals, in their elemental state, are typically too unreactive to act as effective anti-microbials, but may, however, exhibit a much stronger anti-microbial effect when ionized. Thus, the anti-microbial metals have potential anti-microbial properties, which in many cases are realized upon ionization of the metals. When ionized, the anti-microbial metals can also be combined with various reactive gases, for example, nitrogen, or oxygen to form compounds of nitrides or oxides, and combinations thereof.

"Multivalent" as used herein refers to one or more valence states and should be understood to refer to the charge on an ion or the charge that may be assigned to a particular ion based on its electronic state.

Silver oxide, unless otherwise indicated, is defined as the singlet form of silver oxide (AgO).

The term "about" as used herein is intended to indicate that a particular number is not necessarily exact but may be higher or lower as determined by the particular procedure or method used.

PEEK - poly ether ether ketone

PTFE - poly tetra fluoro ethylene

EPTFE - expanded poly tetra fluoro ethylene

UHMWPE is ultra high - molecular weight polyethylene

It is understood that "a" as used to define the claims is not necessarily limited to a single species.

BRIEF DESCRIPTION OF THE DRAWINGS

FIG. 1 is a sketch of an IPD apparatus. 1. Target material, 2. Substrate being coated, 3. Mechanism for moving the substrate closer or further away from the target, 4. Vacuum chamber, and 5. Power supply for the target.

FIG. 2 is another embodiment of the IPD apparatus. 1. Target material, 2. Substrate being coated, 3. Mechanism that has the ability to move the substrate closer or further away from the target, 4. Vacuum chamber, 5. Power supply for the target, and 6. Arc control that determines the speed of the arc.

DETAILED DESCRIPTION OF THE INVENTION

The present invention provides a number of advantages over other state of the art anti-microbial coatings and processes for depositing anti-microbial coatings, including controllable release, embedding the coating into the substrate, lower run temperatures for certain materials, significantly improved throughput in processing efficiency compared with conventional cathodic arc processes, scalability, and application to a wide range of substrate materials.

Additionally, superior coatings unavailable using conventional IPD methods have been obtained, including silver oxide, copper oxide and hafnium nitride coatings. These materials have a higher anti-microbial activity at comparable thicknesses compared to more expensive processes, such as those outlined in U.S. Pat No. 5,454,886, incorporated herein by reference. Thus, thinner coatings and shorter processing time can be achieved with the same anti-microbial results by employing the new IPD-based methods. Higher throughput is possible, which can result in production cost savings and is a very significant advantage, especially for the medical industry.

A factor contributing to the superiority of films obtained using the disclosed process is the discovery that the new IPD process produces an increase, rather than a decrease, in macro particle deposition, which in fact improves film quality. The predominant trend for one skilled in the use of traditional cathodic arc deposition processes has for years been to reduce macro particles deposited in order to produce cleaner and more uniform films. Conventional wisdom in the industry has been that macro-particles in general are deleterious to the quality of deposited films.

The present invention relates to a process of depositing anti-microbial materials onto a selected substrate material. The substrate can be of any material, such as metal, ceramic, plastic, glass, flexible sheets, porous papers, ceramics or combinations thereof. Although the substrate can be any of a number of devices, medical devices are particularly preferred, including catheters, implants, stents, tracheal tubes, orthopedic pins, shunts, drains, prosthetic devices, dental implants, dressings and wound closures. However, it should be understood that the invention is not limited to such devices and may extend to other devices useful in the medical field, such as face masks, clothing, surgical tools and surfaces.

There are two important factors regarding implant infection: the introduction of bacteria during implant surgery; and, transdermal openings following surgery. Transdermal devices are a prime location for infections. As the device separates from the skin, a fissure forms between the skin and device, allowing bacterial contamination.

The present invention, therefore, is related to improved and more economical methods for providing anti-microbial surfaces or other components on medical devices for use in the human body as well as in veterinary and other applications The anti-microbial material can be any solid material or combination of materials having anti-microbial properties. Preferred materials are metals having potential anti-microbial properties and which are biocompatible *(i.e.*, not damaging in the intended environment). Such metals include silver, zinc, niobium, tantalum, hafnium, zirconium, titanium, chromium, nickel, copper, platinum and gold (also referred to herein as "anti-microbial metals"). In accordance with the present invention, anti-microbial metals are deposited onto or into the surface of a substrate by ionizing, in a vacuum, a cathode of a target metal into a plasma of particulate constituents. Ionic plasma deposition devices, such as those described in International Patent Application publication WO 03-044240, the contents of which are herein incorporated by reference, can be modified in accordance with the invention and used to carry out the controlled deposition of the anti-microbial materials in accordance with the described methods.

A factor contributing to the superiority of films obtained using the new IPD process is the discovery that an increase, rather than a decrease, in macro particle deposition in fact improves film quality. The predominant trend for one skilled in the use of cathodic arc deposition processes has for years been to reduce the number of macro particles in order to produce cleaner and more uniform films. Conventional wisdom in the industry is that macro-particles in general are deleterious to the quality of deposited films.

In contrast, an increased amount of macro particles has been found to result in an effective way to control the anti-bacterial activity of silver oxide films. For a quick release of silver into the surrounding tissue, a thick, fairly macro-particle free coating of pure AgO can be applied. For a more tuned release, a time-release scheme is used.

When depositing a coating on a substrate using cathodic arc, the relative amount of macro-particles ejected from the target can be controlled. Macro-particles are molten blobs of metal that are ejected from the target without being fully vaporized. These blobs are dense and comprised of pure target material. The surfaces of these blobs usually are charged, while the bulk of the material is neutral.

When the macro particles pass through the plasma, the outside surface is oxidized, forming an "coated candy" like structure with a coating of AgO on the outside of the particle and pure silver on the inside. This acts like a time-release capsule.

Time-release effects occur due to the inherent instability of the outer "shell" of AgO and a more stable inner "shell" of pure silver. The silver oxide outer coating releases its anti-microbial activity relatively quickly, killing any bacteria in the surrounding area. During the release process, the inner pure silver is oxidized and slowly released to maintain anti-microbial activity over time. The time period is determined by the size of the macro-particle. Thus, specific coatings of specific sizes of macro-particles can be designed to maintain anti-microbial activity for a selected time period. Typical size ranges for macro-particles are 10 nm to 10 microns, depending on the length of time desired to maintain activity.

Elution is an important factor in anti-microbial activity; however the amount of silver eluted is related to the anti-microbial activity of a Ag/AgO coated device. The elution rate must occur at a certain level in order to be effective against infection and biofilm formation. The minimum rate is approximately 0.005 mg Ag per square inch (0.0048 mg/sq inch). The anti-microbial activity of a silver oxide coating prepared by the method disclosed herein will elute at this rate for at least 60 days. Silver/silver oxide coatings prepared by other methods do not elute at a constant rate for longer than a 7 day period.

Another important feature of the present invention is the ability to imbed a silver oxide coating into the surface of the device, thus obtaining superior adhesion compared to coatings deposited by other deposition methods. The imbedding process can be controlled by using the arc control method at a specific distance from the target, so that coatings embedded up to 100 nm and more for plastics and up to 10 nm and more for metals and ceramics can be obtained.

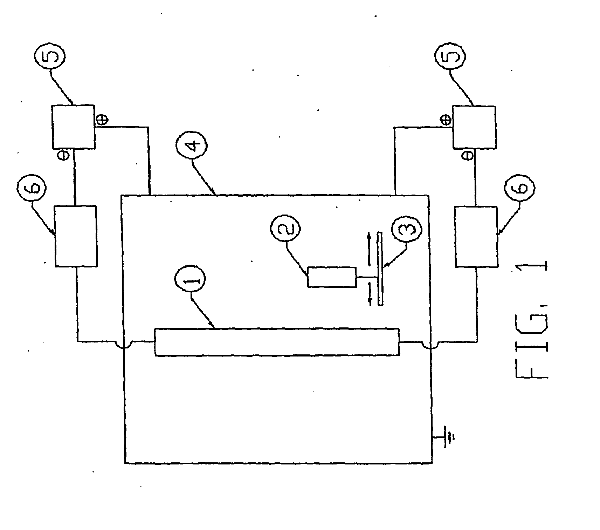

A suitable device for carrying out the ionic plasma deposition process is illustrated in FIG. 1. As shown in FIG. 1, a cathode 1 of the target material is disposed within a vacuum chamber 4. The cathode 1 is ionized by generating an arc at the cathode from a power supplied by a power source 5 to the cathode. The plasma constituents are selected, controlled or directed toward the substrate by a controlling mechanism 3 that moves the substrate 2 toward or away from the target 1.

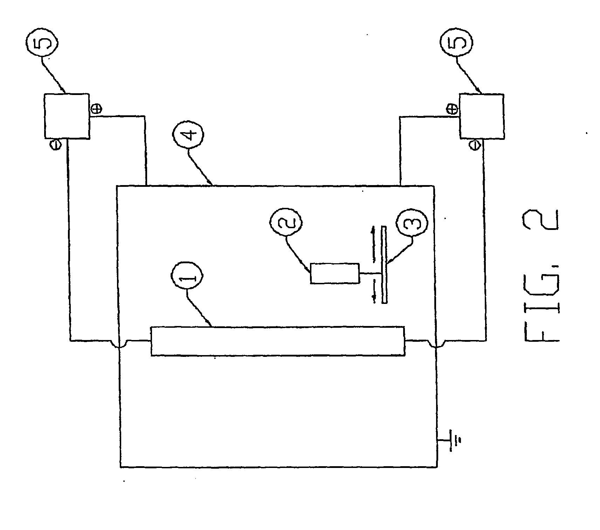

Additional control of the power supply 6 as shown in FIG. 2 can also be used to provide further control of the plasma constituents by controlling arc speed.

In the case where the desired anti-microbial metal is silver, for example, a silver cathode is placed in the vacuum chamber of the ionic plasma deposition device, along with a selected substrate. The silver used as the cathode is preferably medical grade *(i.e*. 99.99% pure) silver to avoid any potentially toxic materials, although silver metal of lower purity can also be used.

The chamber is pumped to a suitable working pressure typically in the range of 0.0133322 Pa (0.1 mT) to 3.99966 Pa (30 mT), however, the ability of the IPD process to produce effective antimicrobial surfaces having sustained release rates is not dependent on any specific working pressure within the typical range of 0.0133322 Pa (0.1 mT) to 3.99966 Pa (30 mT). Similarly, the ionic plasma deposition process is not dependent upon operating temperature. Typical operating temperatures are in the range of 25 to 75° C and any temperature within this range is suitable for producing anti-microbial surfaces.

The substrate can be rotated, such as on turntables, or rolled past the deposition area in any orientation relative to the trajectory of the incoming deposition material. Power is supplied to the cathode to generate an electric arc at the cathode. This power can range from a few amps of current to several hundred amps, at a voltage appropriate for the source material. Voltage is typically in the range of 12 volts to 60 volts, and is appropriately scaled to the size of the source material, which can be a few inches to several feet in length. The electric arc ionizes the silver metal cathode into a plasma of silver ions, neutrally charged particles and electrons. Oxygen is introduced into the plasma at a typical rate of 10 to 1000 sccm and combines with the silver ions to form silver oxide particles. The silver oxide particles can have a particle size ranging from less than 1 nanometer to about 50 microns, depending upon the desired ion release rate and ultimate use of the substrate.

It is also possible to control the metal ion release rate of the anti-microbial surfaces in order to obtain an effective release rate over a sustained period of time. Such controlled metal release is obtained by depositing a combination of oxides of various structures, including monovalent, divalent and multivalent oxides, onto the substrate. Combinations of oxides exhibit different ion release rates which contribute to the control of ion concentrations and the sustained release of the metal ions for enhanced anti-microbial activity. Multivalent oxides can also be created on neutral metal particles as they are oxidized in the plasma. This further enhances the sustained release of the deposited materials by creating combinations of oxides of various sizes and valence states. The benefit of such combinations is an increase in ion release over a longer period of time. The silver oxide particles are then deposited onto the substrate surface in the form of a dispersion of silver oxide particles.

The effectiveness of the anti-microbial surface in delivering an anti-microbial response is also dependent upon the processing time for forming the anti-microbial surface. Longer processing times from 5 seconds to multiple minutes result in anti-microbial surfaces having different anti-microbial responses.

Controlled metal release is also obtained by depositing a combination of different metal oxides onto the substrate. These combinations include silver and titanium, silver and gold, silver and copper, silver copper and gold. Other materials can be combined as codeposited metals, alloys or as alternating layers in various combinations. Control and flexibility of the plasma environment allows a much larger range of combinations and, accordingly, a wide range of customized coatings.

The invention is further illustrated by the following non-limiting examples.

EXAMPLES

Materials and Methods

**Sample Elution Testing** - Elution testing was performed to determine the silver elution profile of coated Polypropylene samples. Silver elution testing provides a quantitative method for determining the amount of silver released from the test article over a specified period of time. The testing was conducted according to the current FDA Good Laboratory Practice, GLP, Standards, 21 CFR, Part 58. Each test article was extracted in USP 0.9% NaCl for injection at a temperature of 37° ±1° C for silver elution analysis by Inductively Coupled Plasma (ICP) Spectroscopy. Each sample is separately placed in 10 mL of USP 0.9% NaCl for a specified period of time. The time periods used during this study were 15 min., 30 min., 1 hr, 2 hr, 4 hr, 8 hr, 24 hr, days 2-7, day 10, day 15, day 20, day 25, and day 30. At each time point, the fluid surrounding the sample was decanted into a clean glass container and fresh NaCl was added to the sample container. The decanted liquid was brought to a total volume of 50 mL with deionized water, then acid digested and examined by ICP for silver content.

**Sample Zone of Inhibition (ZOI) Testing** - ZOI testing is an easy, 24 hour test anti-microbial activity. The test is not quantitative, and only provides enough information to indicate if a serial dilution test is warranted. This test provides no information regarding tissue re-growth or necrosis.

**Sample Serial Dilution Testing** - Serial dilution testing provides an accurate measure of the amount of bacteria per given volume. When compared to a control sample, it can provide a quantitative measure of anti-microbial coating activity.

A standard bacterial solution is prepared from a 0.5 McFarland standard. The standard is calibrated to read between 0.08 and 0.1 OD at 625 nm, which gives a standardized bacterial count of 1.5 X 10⁸ cfu/mL.

While the following embodiments of the present invention have been described in detail, it is apparent that modifications and adaptations of those embodiments will occur to those of skill in the art. It is to be understood that such modifications are within the scope of the invention.

EXAMPLE 1. Silver Coated Catheter (published method)

A solver-coated catheter was prepared using the same procedure described in Example 6 of U.S. Patent No. 5,454,886. Silver metal was deposited on 2.5 cm sections of a latex Foley catheter using magnetron sputtering. Operating conditions were performed as closely as possible based on the published example; *i.e*., the deposition rate was 20 nm (200 A°) per minute; the argon working gas pressure was (3.99966 Pa (30 m Torr); and the ratio of temperature of substrate to melting point of the coating metal silver, T/Tm was 0.30. In this example, the angles of incidence were variable since the substrate was round and rough; that is, the angles of incidence varied around the circumference and, on a finer scale, across the sides and tops of the numerous surface features. The anti-microbial effect on *S. aureus* was tested by a zone of inhibition, (Table 1).

**TABLE 1**

| | Reported Results 5,454,886 patent | Experimental Results |
|---|---|---|
| Zone of inhibition | 0.5 mm | |
| T/Tm | 0.38 | |
| Zone of inhibition | 16 mm | <1 mm |
| T/Tm | 0.30 | 0.30 |

Under the same T/Tm conditions, previously published, and repeating the same conditions as set forth in Example 6 of the 5,454,889 patent, the observed zone of inhibition (ZOI) around the tubing was significantly less than the reported ZOI. The ZOI test was performed using *S. aureus* as reported in example I of the 5,454,886 patent.

EXAMPLE 2. DC magnetron sputtered antimicrobial coating (published method).

The procedure of Example 7 in the 5,454,886 patent was followed. A Teflon coated latex Foley catheter was coated by DC magnetron sputtering 99.99% pure silver on the surface using the conditions used were: 0.5 kW power, 5.33288 Pa (40 mTorr) Ag/O₂, 20 °C initial substrate temperature, a cathode/anode distance of 100 mm, and a final film thickness of 300 nm. The working gases used were commercial Ag and 99/1 wt % Ag/O₂.

The anti-microbial effect of the coating was tested by a zone of inhibition test. Mueller Hinton agar was dispensed into Petri dishes. The agar plates were allowed to surface dry prior to being inoculated with a lawn of *Staphylococcus aureus* ATCC#25923. The inoculant was prepared from Bactrol Discs (Difco, M.) which were reconstituted per the manufacturer's directions. Immediately after inoculation, the coated materials to be tested were placed on the surface of the agar. The dishes were incubated for 24 hr. at 37°C. After the incubation period, the ZOI was measured and a corrected zone of inhibition was calculated as follows: corrected zone of inhibition=zone of inhibition-diameter of the test material in contact with the agar. The published results showed no zone of inhibition for the uncoated samples. A corrected zone of inhibition of 11 mm was reported for catheters sputtered in the 99/1 wt.% Ag/O₂ using a working gas pressure of 5.33288 Pa (40 mTorr).

The experiment was repeated under the published conditions listed in Table 2. A small ZOI of less than one mm was observed.

**TABLE 2**

| **Conditions of DC Magnetron Sputtering Used for** **Anti-Microbial Coatings** | | | |
|---|---|---|---|
| **Samples Sputtered in** **Commercial Argon** | | **Samples Sputtered in** **99/1 wt % Ar/O₂** | |
| Power | 0.1 kW | Power | 0.5 kW |
| Argon Pressure: | 0.66661 Pa (5 m Torr) | Ag/O₂ Pressure: | 5,33288Pa (40 m Torr) |
| Initial Substrate | 20° C. | Initial Substrate | 20° C. |
| Temperature: | | Temperature: | |
| Cathode/Anode | 40 mm | Cathode/Anode | 100 mm |
| Distance: | | Distance: | |
| Film Thickness: 250 nm | (2500 Å) | Film Thickness: | 300 nm (3000 Å) |
| ZOI (reported) | 0 | 11 mm | |
| | | | |
| Experimental (repeat under published conditions above) Results | | | |
| ZOI | 0 | <1 mm | |

In repeating the above published conditions, the experimental results showed a small ZOI of less then one mm.

EXAMPLE 3. Composite Silver Anti-microbial Films (published method)

This example demonstrates a state of the art procedure for preparing a composite anti-microbial coating formed by reactive sputtering as found in Example 11 of the 5,454,886 patent. Table 3 lists the published sputtering conditions and the conditions used for the comparison study compared with Experimental results obtained by following the steps in the published procedure.

**TABLE 3**

| Sputtering Conditions | | |
|---|---|---|
| Published | | Experimental |
| Target | 99.99% Ag | 99.99% |
| Working gas | 80/20% Ar/O2 | 80/20% ArO2 |
| Working gas P | 0.333305 - 6.6661 Pa (2,5-50 mTorr) | 5.33288 Pa (40 mTorr) |
| Power | 0.1-2.5 kW | 0.5 kW |
| Substrate T | -5 to 20° C | 20° C |
| Anode/Cathode Distance | 40 to 100 mm | 100 mm |
| Base P | 0.0533288 Pa (<4x10⁻⁴ Torr) | |
| ZOI | 6-12 mm | 0 to 2 mm |

EXAMPLE 4 *in vitro* testing of silver oxide coated catheters

This example demonstrates the effectiveness of the antimicrobial coating over a range of gram positive and gram negative organisms. The organisms tested for general zone of inhibition were: Gram positive *bacteria E. faecalis, S. aureus* MR, and *S. epidermis.* Gram negative bacteria were *E*. *coli, K pneumoniae,* and *P. aerugosia.*

The method used to test for a ZOI was plate-to-plate transfer maximum for 4 days. Each of the above listed bacteria was plated out on tryptic soy agar. The pre-made plate was inoculated with the bacterium, divided into three equal sections, and a one inch long Foley catheter sample coated with 200 nm of silver oxide was placed in the center of each part after inoculation. The samples were placed in an incubator at 37°C and the ZOI was measured at 24, 48, 72 and 96 hours.

Total ZOI is defined as the ZOI minus the width of the sample. For this experiment, measurements were made of the total ZOI and divided in half. If there was no measurable ZOI and no biofilm, and organism did not grow over or attach to the sample, the measurement was noted as 0.0mm. When a biofilm was observed, it was recorded as - 1.0mm. Plate to plate transfer was repeated until a biofilm was noted or a measurement of 0.0mm was recorded for 2 transfers. Each organism had three plates and each plate had three data points for the side-by-side sample and control catheter. Measurements were taken daily. The three measurements per plate were averaged to get a daily plate ZOI. This was done to compensate for swipes being too heavy or light in concentration. All measurements taken were recorded in mm. A measurement of 0.0 indicated that the organism grew to the silver sample but did not adhere or create a biofilm on the silver sample catheter. All control samples had biofilms from Day 1 without exceptions. Results are shown in Table 4.

**TABLE 4**

| | | | | | | | | | |
|---|---|---|---|---|---|---|---|---|---|
| **Day1** | | | | | | | | | |

| | **Plate 1** | **Plate 1** | **Control Plate 1** | **Plate 2** | **Plate 2** | **Control Plate 2** | **Plate 3** | **Plate 3** | **Control Plate 3** |
|---|---|---|---|---|---|---|---|---|---|
| **E. faecalis (+)** | Zone Width (mm) | ZOI | | Zone Width (mm) | ZOI | | Zone Width (mm) | ZOI | |
| **Day1** | 2.0 | 1.0 | 0.0 | 3.0 | 1.5 | 0.0 | 1.0 | 0.5 | 0.0 |
| | 3.0 | 1.5 | 0.0 | 4.0 | 2.0 | 0.0 | 4.0 | 2.0 | 0.0 |
| | 3.0 | 1.5 | 0.0 | 3.0 | 1.5 | 0.0 | 3.0 | 1.5 | 0.0 |
| **Day2** | 0.0 | 0.0 | 0.0 | 0.0 | 0.0 | 0.0 | 0.0 | 0.0 | 0.0 |
| | 0.0 | 0.0 | 0.0 | 0.0 | 0.0 | 0.0 | 0.0 | 0.0 | 0.0 |
| | 0.0 | 0.0 | 0.0 | 0.0 | 0.0 | 0.0 | 0.0 | 0.0 | 0.0 |
| **Day3** | 0.0 | 0.0 | 0.0 | 0.0 | 0.0 | 0.0 | 2.0 | 1.0 | 0.0 |
| | 0.0 | 0.0 | 0.0 | 0.0 | 0.0 | 0.0 | 3.0 | 1.5 | 0.0 |
| | 0.0 | 0.0 | 0.0 | 0.0 | 0.0 | 0.0 | 4.0 | 2.0 | 0.0 |
| **S. epidermis (+)** | | | | | | | | | |
| **Day1** | 3.0 | 1.5 | 0.0 | 9.0 | 4.5 | 0.0 | 2.0 | 1.0 | 0.0 |
| | 3.0 | 1.5 | 0.0 | 12.0 | 6.0 | 0.0 | 9.0 | 4.5 | 0.0 |
| | 8.0 | 4.0 | 0.0 | 10.0 | 5.0 | 0.0 | 8.0 | 4.0 | 0.0 |
| **Day2** | 1.0 | 0.5 | 0.0 | 0.0 | 0.0 | 0.0 | 2.0 | 1.0 | 0.0 |
| | 0.0 | 0.0 | 0.0 | 1.0 | 0.5 | 0.0 | 4.0 | 2.0 | 0.0 |
| | 2.0 | 1.0 | 0.0 | 0.0 | 0.0 | 0.0 | 2.0 | 1.0 | 0.0 |
| **Day3** | 3.0 | 1.5 | 0.0 | 6.0 | 3.0 | 0.0 | 5.0 | 2.5 | 0.0 |
| | 0.0 | 0.0 | 0.0 | 4.0 | 2.0 | 0.0 | 6.0 | 3.0 | 0.0 |
| | 2.0 | 1.0 | 0.0 | 3.0 | 1.5 | 0.0 | 6.0 | 3.0 | 0.0 |
| **Day4** | 1.0 | 0.5 | 0.0 | 2.0 | 1.0 | 0.0 | 0.0 | 0.0 | 0.0 |
| | 4.0 | 2.0 | 0.0 | 2.0 | 1.0 | 0.0 | 2.0 | 1.0 | 0.0 |
| | 2.0 | 1.0 | 0.0 | 2.0 | 1.0 | 0.0 | 2.0 | 1.0 | 0.0 |
| **E. Coli (-)** | | | | | | | | | |
| **Day1** | 2.0 | 1.0 | 0.0 | 5.0 | 2.5 | 0.0 | 0.0 | 0.0 | 0.0 |
| | 7.0 | 3.5 | 0.0 | 2.0 | 1.0 | 0.0 | 0.0 | 0.0 | 0.0 |
| | 1.0 | 0.5 | 0.0 | 10.0 | 5.0 | 0.0 | 6.0 | 3.0 | 0.0 |
| **Day2** | 0.0 | 0.0 | 0.0 | 4.0 | 2.0 | 0.0 | 0.0 | 0.0 | 0.0 |
| | 4.0 | 2.0 | 0.0 | 5.0 | 2.5 | 0.0 | 0.0 | 0.0 | 0.0 |
| | 2.0 | 1.0 | 0.0 | 2.0 | 1.0 | 0.0 | 0.0 | 0.0 | 0.0 |
| **Day3** | 2.0 | 1.0 | 0.0 | 4.0 | 2.0 | 0.0 | 0.0 | 0.0 | 0.0 |
| | 1.0 | 0.5 | 0.0 | 4.0 | 2.0 | 0.0 | 0.0 | 0.0 | 0.0 |
| | 1.0 | 0.5 | 0.0 | 3.0 | 1.5 | 0.0 | 0.0 | 0.0 | 0.0 |
| **Day4** | 0.0 | 0.0 | 0.0 | 0.0 | 0.0 | 0.0 | 0.0 | 0.0 | 0.0 |
| | 0.0 | 0.0 | 0.0 | 2.0 | 1.0 | 0.0 | 0.0 | 0.0 | 0.0 |
| | 0.0 | 0.0 | 0.0 | 2.0 | 1.0 | 0.0 | 0.0 | 0.0 | 0.0 |
| **K. pneumoniae (-)** | | | | | | | | | |
| **Day1** | 1.0 | 0.5 | 0.0 | 1.0 | 0.5 | 0.0 | 1.0 | 0.5 | 0.0 |
| | 3.0 | 1.5 | 0.0 | 4.0 | 2.0 | 0.0 | 4.0 | 2.0 | 0.0 |
| | 2.0 | 1.0 | 0.0 | 1.0 | 0.5 | 0.0 | 2.0 | 1.0 | 0.0 |
| **Day2** | 0.0 | 0.0 | 0.0 | 0.0 | 0.0 | 0.0 | 0.0 | 0.0 | 0.0 |
| | 1.0 | 0.5 | 0.0 | 4.0 | 2.0 | 0.0 | 3.0 | 1.5 | 0.0 |
| | 0.0 | 0.0 | 0.0 | 0.0 | 0.0 | 0.0 | 0.0 | 0.0 | 0.0 |
| **Day3** | 0.0 | 0.0 | 0.0 | 0.0 | 0.0 | 0.0 | 2.0 | 1.0 | 0.0 |
| | 0.0 | 0.0 | 0.0 | 0.0 | 0.0 | 0.0 | 3.0 | 1.5 | 0.0 |
| | 0.0 | 0.0 | 0.0 | 0.0 | 0.0 | 0.0 | 4.0 | 2.0 | 0.0 |
| **P. aerugosia (-)** | | | | | | | | | |
| **Day1** | 1.0 | 0.5 | 0.0 | 6.0 | 3.0 | 0.0 | 2.0 | 1.0 | 0.0 |
| | 2.0 | 1.0 | 0.0 | 7.0 | 3.5 | 0.0 | 4.0 | 2.0 | 0.0 |
| | 1.0 | 0.5 | 0.0 | 5.0 | 2.5 | 0.0 | 2.0 | 1.0 | 0.0 |
| **Day2** | 0.0 | 0.0 | 0.0 | 4.0 | 2.0 | 0.0 | 1.0 | 0.5 | 0.0 |
| | 1.0 | 0.5 | 0.0 | 5.0 | 2.5 | 0.0 | 0.0 | 0.0 | 0.0 |
| | 1.0 | 0.5 | 0.0 | 4.0 | 2.0 | 0.0 | 1.0 | 0.5 | 0.0 |
| **Day3** | 0.0 | 0.0 | 0.0 | 3.0 | 1.5 | 0.0 | 2.0 | 1.0 | 0.0 |
| | 0.0 | 0.0 | 0.0 | 3.0 | 1.5 | 0.0 | 3.0 | 1.5 | 0.0 |
| | 0.0 | 0.0 | 0.0 | 3.0 | 1.5 | 0.0 | 4.0 | 2.0 | 0.0 |
| **S. aureus MR (+)** | | | | | | | | | |
| **Day1** | 2.0 | 1.0 | 0.0 | 5.0 | 2.5 | 0.0 | 1.0 | 0.5 | 0.0 |
| | 3.0 | 1.5 | 0.0 | 2.0 | 1.0 | 0.0 | 2.0 | 1.0 | 0.0 |
| | 2.0 | 1.0 | 0.0 | 10.0 | 5.0 | 0.0 | 0.0 | 0.0 | 0.0 |
| **Day2** | 3.0 | 1.5 | 0.0 | 4.0 | 2.0 | 0.0 | 0.0 | 0.0 | 0.0 |
| | 2.0 | 1.0 | 0.0 | 5.0 | 2.5 | 0.0 | 0.0 | 0.0 | 0.0 |
| | 5.0 | 2.5 | 0.0 | 2.0 | 1.0 | 0.0 | 0.0 | 0.0 | 0.0 |
| **Day3** | 0.0 | 0.0 | 0.0 | 4.0 | 2.0 | 0.0 | 3.0 | 1.5 | 0.0 |
| | 0.0 | 0.0 | 0.0 | 4.0 | 2.0 | 0.0 | 4.0 | 2.0 | 0.0 |
| | 0.0 | 0.0 | 0.0 | 3.0 | 1.5 | 0.0 | 3.0 | 1.5 | 0.0 |
| **Day4** | 0.0 | 0.0 | 0.0 | 0.0 | 0.0 | 0.0 | 2.0 | 1.0 | 0.0 |
| | 0.0 | 0.0 | 0.0 | 2.0 | 1.0 | 0.0 | 3.0 | 1.5 | 0.0 |
| | 0.0 | 0.0 | 0.0 | 2.0 | 1.0 | 0.0 | 3.0 | 1.5 | 0.0 |

EXAMPLE 5 *in vivo* testing of a silver oxide coated catheter

This example demonstrates in *vivo* testing of two identical pieces of catheter material with a 200 nm silver oxide coating in a rabbit. The test devices were ETO-sterilized. For each of the two catheter pieces, four segments of the antimicrobial portion of the catheter (approximately 4 inches in length) were prepared. The test devices were used as provided and maintained at room temperature.

A total of eight catheter segments (four segments of each catheter material) were implanted into a female New Zealand White rabbit. Prior to implantation on Day 1, the animal was weighed and anesthetized with an intravenous injection of a ketamine/xylazine cocktail (87 mg/mL ketamine, 13 mg/mL xylazine) at 0.1 mL/kg. The animal was 23-25 weeks old and weighed 2.63 kg on Day 1.

One week following catheter implantation, a challenge organism (*S. aureus* or *E. coli)* was placed on the skin around each catheter entry site (two segments of each catheter material challenged with *S. aureus* and the remaining two segments of each catheter material challenged with *E. coli).* The animal was sacrificed 48 hours following bacterial challenge.

The treatment parameters are described below in Table 5. The bacterial challenge took place on Day 8, in accordance with the protocol used.

**TABLE 5**

| Group | No. | Implantation (8 implant sites) | Route | Implant Site | Bacterial Challenge | Necropsy (Day) |
|---|---|---|---|---|---|---|
| A | 1 | 1 catheter segment/site | Percutaneous | Perispinal | Day 8 | Day 10 |

The paravertebral area was clipped with electric clippers and prepared with povidone iodine and 70% alcohol. The animal had eight implantation sites along the back. Each site was 2.5-5.0 cm from the midline and sites were approximately 2.5 cm apart. Implant sites were identified by permanent marker.

At each implant site, the skin was punctured into the muscle with a 16-gauge needle. The catheter segment was fed down the ID of the needle into the muscle and the needle removed, leaving half of the catheter segment implanted through the skin into the muscle. One section of catheter material was implanted at each site. The rabbit was implanted with four segments of each of the two identical pieces, for a total of eight implants. The exposed catheter segment was covered with a sterile dressing. Locations of the implant sites on the animal's back are identified in Table 6.

**TABLE 6**

| Site No. | Side | Region | Implanted Material |
|---|---|---|---|
| 1 | Left | Cranial | 3659-16 |
| 2 | Left | Cranial - Middle | 3659-16 |
| 3 | Left | Caudal - Middle | 3659-17 |
| 4 | Left | Caudal | 3659-17 |
| 5 | Right | Cranial | 3659-16 |
| 6 | Right | Cranial - Middle | 3659-16 |
| 7 | Right | Caudal - Middle | 3659-17 |
| 8 | Right | Caudal | 3659-17 |

On Day 8, the sterile dressing was removed from each exposed catheter segment. The skin around each catheter entry site received a surface instillation of a 1 mL suspension containing 2.2 x 10⁵ CFU/mL of *S. aureus* or 5. 10 x 10² CFU/mL of *E. coli.* One segment of each catheter material was challenged with *S. aureus* and one segment of each catheter material was challenged with *E. coli.* Following inoculation, the catheter segments were re-covered with a sterile dressing. The inoculating organism used at each site is listed in Table 7.

**TABLE 7**

| Site No. | Side | Region | Implanted Material | Inoculating Organism | Comments |
|---|---|---|---|---|---|
| 1 | Left | Cranial | 3659-16 | *S. aureus* | Administered 1 mL bacteria suspension topically |
| 2 | Left | Cranial - Middle | 3659-16 | N/A¹ | N/A |
| 3 | Left | Caudal - Middle | 3659-17 | N/A¹ | N/A |
| 4 | Left | Caudal | 3659-17 | N/A¹ | N/A |
| 5 | Right | Cranial | 3659-16 | N/A¹ | N/A |
| 6 | Right | Cranial - Middle | 3659-16 | *E. coli* | Administered 1 mL bacteria suspension topically |
| 7 | Right | Caudal - Middle | 3659-17 | *E. coli* | Administered 1 mL bacteria suspension topically |
| 8 | Right | Caudal | 3659-17 | *S. aureus* | Administered 1 mL bacteria suspension topically |

| | | | | | |
|---|---|---|---|---|---|
| N/A = Not applicable | | | | | |

On Day 10, the animal was euthanized with an intravenous injection of a commercial euthanasia solution according to Brain Chemistry Optimization Program protocol 01-11-21-22-02-026. The entire implant was collected aseptically and submitted for quantitative bacterial determination. A superficial swab of the tract area of muscle and skin was taken. Swabs were not collected in this study because several catheters had backed out and the implant tract was not visible. A portion of the muscle around the implant tract was placed in 10% neutral buffered formalin and submitted to Colorado Histo-Prep (Fort Collins, CO) for evaluation by a board-certified veterinary pathologist. For four of the eight implant sites (Site Nos. 1, 6, 7, and 8), the internal and external portions of the implant were collected separately into Tryptic Soy Broth. These were the sites that still had a portion of the catheter exiting the skin.

Clinical observations showed the rabbit remained healthy and showed no signs of infection, as seen in Table 8.

**TABLE 8 Clinical observations of rabbit health**

| Group | Animal No. | Day | Clinical Observations | | |
|---|---|---|---|---|---|
| | | | General | Stool | Appetite |
| A | 17 | 2-3 | G0 | S0 | A0 |
| | | 4-5 | G0 | S1 | A0 |
| | | 6-8 | G0 | S0 | A0 |
| | | 9-10 | G0 | S1 | A0 |

| | | | | | |
|---|---|---|---|---|---|
| Key: G0 = Appeared normal; bright, alert and responsive S0 = Stool normal S1 = Stool soft A0 = Normal amount of food consumed | | | | | |

For each test material, one implant site was inoculated with *S. aureus* and one implant site was inoculated with *E*. *coli* (Site Nos. 1, 6, 7, and 8). For the inoculated sites, two implant locations, identified as internal and external, were evaluated for microbial growth and identification. The catheter sections above the skin were identified as the external implant sites and the catheter sections below the skin were identified as the internal implant sites.

For the remaining four implant sites (Site Nos. 2-5), no inoculation was performed, as there was no visible implant external to the skin on the day of inoculation (Day 8). For these sites, subcutaneous portions of the catheter were evaluated for microbial growth and identification.

For the site implanted with the 3659-16 catheter material and challenged with *S. aureus* (Site No. 1), positive growth of the challenge organism was identified at both the internal and external implant sites. For the site implanted with the 3659-16 catheter material and challenged with E. *coli* (Site No. 6), bacterial growth identified as *Staphylococcus hominis* was present at the internal implant site; this growth was due to environmental contamination. At this site, no growth of the challenge organism *(E. coli)* was identified at the internal or external implant site.

For the site implanted with the 3659-17 catheter material anti challenged with *S, aureus* (Site No. 8), positive growth of the challenge organism was identified at the external implant site only. For the site implanted with the 3659-17 catheter material and challenged with *E. coli* (Site No. 7), no growth was present at the internal or external implant site.

For the remaining four implant sites, which were not inoculated (Site Nos. 2-5), no bacterial growth was present. See Table 9.

**TABLE 9**

| **Microbiological Growth Results From Implant sites** | | | | | | |
|---|---|---|---|---|---|---|
| Group | Animal No. | Implant Site | Implanted Material | Microbiological Growth Identification | | |
| | | | | Challenge Organism | Culture results | Bacterial ID |
| A | I7 | 1 - Internal | 3659-16 | *S. aureus* | Positive Growth | *S. aureus* |
| | | 1 - External | 3659-16 | *S. aureus* | Positive Growth | *S. aureus* |
| | | 2 | 3659-16 | No bacteria applied | No Growth | N/A |
| | | 3 | 3659-17 | No bacteria applied | No Growth | N/A |
| | | 4 | 3659-17 | No bacteria applied | No Growth | N/A |
| | | 5 | 3659-16 | No bacteria applied | No Growth | N/A |
| | | 6 - Internal | 3659-16 | *E. coli* | Positive Growth | S. *hominis* |
| | | 6 - External | 3659-16 | *E. coli* | No Growth | N/A |
| | | 7 - Internal | 3659-17 | *E. coli* | No Growth | N/A |
| | | 7 - External | 3659-17 | *E. coli* | No Growth | N/A |
| | | 8 - Internal | 3659-17 | *S. aureus* | No Growth | N/A |
| | | 8 - Exernal | 3659-17 | *S. aureus* | Positive Growth | *S. aureus* |

| | | | | | | |
|---|---|---|---|---|---|---|
| N/A = Not applicable | | | | | | |

There was no grossly visible evidence of tissue reaction or infection at any of the implant sites. For all implant sites, there was black to gray discoloration of the subcutaneous fascia and muscle at location of the implant. Results are summarized in Table 10.

**TABLE 10**

| **Necropsy observations** | | | | | |
|---|---|---|---|---|---|
| Group | Animal No. | Implant Site | Implanted Material | Necropsy Observations | |
| | | | | Location Condition | General Observations² |
| A | 17 | 1 | 3659-16 | Catheter pulled out of muscle | No grossly visible evidence of tissue reaction or infection |
| | | 2 | 3659-16 | Portion of catheter in muscle, Did back out half way | No grossly visible evidence of tissue reaction or infection |
| | | 3 | 3659-17 | Portion of catheter in muscle | No grossly visible evidence of tissue reaction or infection |
| | | 4 | 3659-17 | Portion of catheter still in muscle | No grossly visible evidence of tissue reaction or infection |
| | | 5 | 3659-16 | Portion of catheter still in muscle | No grossly visible evidence of tissue reaction or infection |
| | | 6 | 3659-16 | Catheter pulled out of muscle | No grossly visible evidence of tissue reaction or infection |
| | | 7 | 3659-17 | Catheter pulled out of muscle | No grossly visible evidence of tissue reaction or infection |
| | | 8 | 3659-17 | Catheter pulled out of muscle | No grossly visible evidence of tissue reaction or infection |

| | | | | | |
|---|---|---|---|---|---|
| N/A = Not applicable | | | | | |

The results showed that the silver/silver oxide impregnated antimicrobial catheters prevented the formation of bacteria, bacterial colonies, and biofilms. The antimicrobial results were consistent across all implant sites, and the antimicrobial coating remained effective even following a microbial challenge at Day 8 with *E. coli* or *S. aureus.* There was no necrosis observed. The lesions were consistent with a foreign body reaction in the muscle, with a more acute inflammatory reaction in the subcutaneous tissue.

EXAMPLE 6 Elution of silver oxide coating

A total of twenty test samples, one cm² polypropylene coated with the typical silver oxide coating were evaluated. Two samples were taken from a total of ten different samples for both the test groups. The testing was performed in duplicate using inductively coupled plasma analysis to determine the amount of silver present at each time point. The values were then averaged for a total of ten reported values for each test group. The elution values are given as mg/sample, which in this case is mg/square inch.

The samples all exhibited a consistent behavior over the first 24 hours in the NaCl solution There was a slight peak around the four hour time point, before the values leveled off around the 24 hour time point.

All of the samples were very consistent in their behavior. The values were fairly stable from day 1 through day 5; the values then peaked around the 6 day time point and then leveled off from day 7 through day 30.

The average elution for the coated Polypropylene samples over all time points is approximately 0.005 mg per 6.4516 cm² (square inch) (0.0048 mg/sq inch). The samples show a fairly consistent silver elution over the entire length the study with slight peaks noted at the 4 hour time point and after 6 days in saline solution Using the elution values and an approximate total silver value of 1.05 mg per 6.4516 cm² (sq inch) (obtained from outside testing) for the Polypropylene.

EXAMPLE 7 *in vivo* healing test of ePTFE coated substrate

This example demonstrates through in vivo testing the ability of the 200 nm silver oxide coating to not cause necrosis. 1 cm² ePTFE samples were coated with the standard 200 nm silver oxide coating and implanted in a rabbit subcutaneously as outlined in example 6 above. The Substrates were explanted at 9 and 22 days to study the healing of the tissue surrounding the implanted silver oxide coated part. The results are outlined in Table 11.

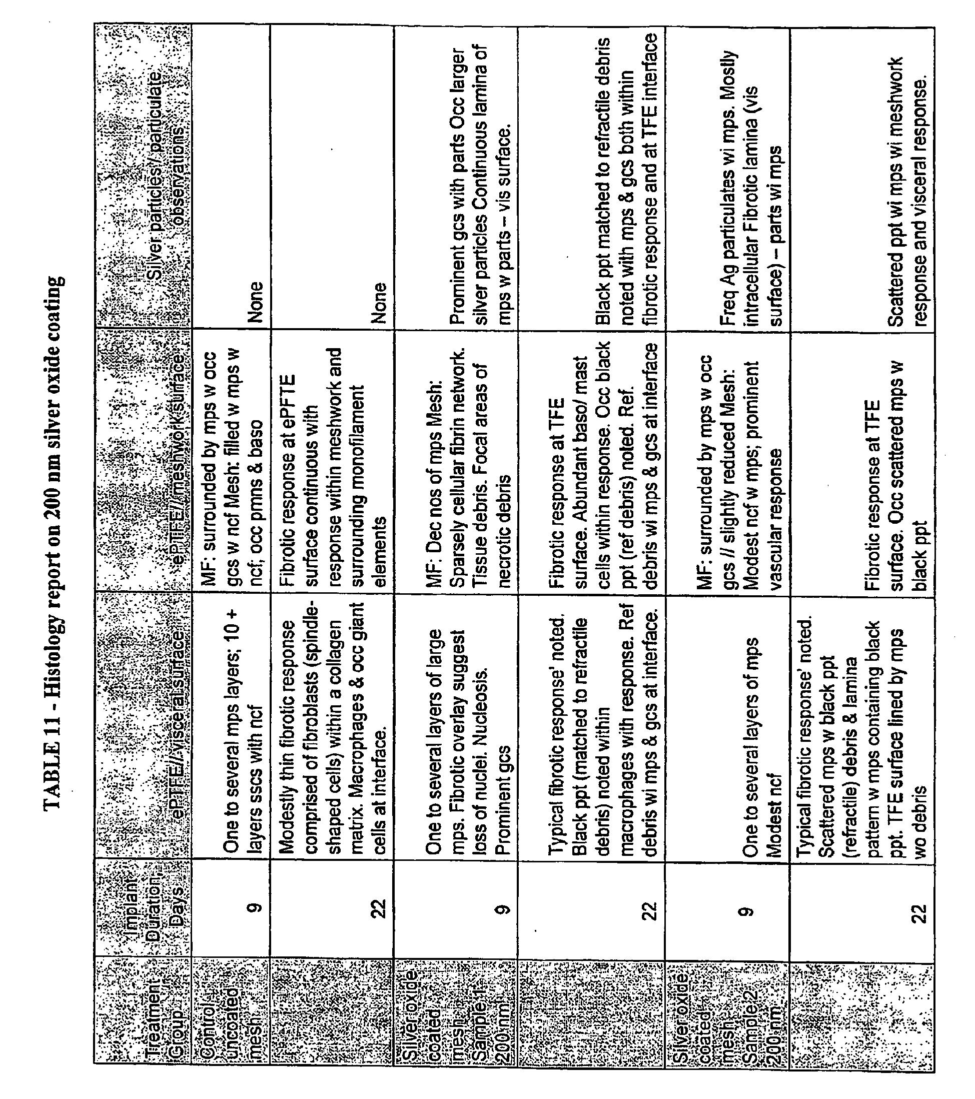

The abbreviations used in Table 11 are as follows:

| | |
|---|---|
| **Occ** | occasional |
| **PMSs** | polymorphonuclear cells |
| **Mps** | mucopolysaccharides |
| **SSCs** | spindle-shaped cells |
| **MF** | microfiber |
| **Base** | basophils |
| **W** | with |
| **Ncf** | neutrophil chemotactic factor |

EXAMPLE 8 - Cathodic Arc Deposition with Moveable Substrate

This example demonstrates how a moveable substrate affects the macro-particle size, thus controlling the release of the silver oxide.

The substrate, substrate one, was placed in a moveable holder at a distance of 30 inches from the target. The chamber was pumped to a level of 0.066661 Pa (5E-4 Torr). The arc was initiated with a current of 100 amps and 16 volts. Oxygen was introduced into the chamber at a rate of 200 SCCM. The substrate was translated closer to the target at a speed of one inch every 15 seconds. This was continued until the substrate was 8 inches away from the target.

In a complementary experiment, a substrate, substrate two, was placed at a distance of 30 inches from the target with the same current, voltage, total time and rate of oxygen flow. This time, the substrate was left stationary.

Initial ZOI testing showed the same size zone in a 24 hour period. Plate transfer was performed for several bacteria and the results are shown in Table 12. It is seen that the substrate that was moved toward the target during the deposition process showed anti-microbial activity for a longer period of time than did the substrate that was left stationary.

In addition to the ZOI testing, cross sections of the two substrates were examined using SEM analysis. In sample one, the amount and size of macro-particles increased with the thickness of the film; *i.e*., there were fewer and smaller macro-particles close to the substrate, and the number and size increased as the thickness of the film grew. Conversely, the cross section in sample two was uniform with very few macro-particles.

**TABLE 12**

| | | | | | | |
|---|---|---|---|---|---|---|
| **Day1** | | | | | | |

| | **Substrate** | **1** | | **Substrate** | **2** | |
|---|---|---|---|---|---|---|
| | **Plate 1 ZOI (mm)** | **Plate 2 ZOI (mm)** | **Control Plate** | **Plate 1 ZOI (mm)** | **Plate 2 ZOI (mm)** | **Control Plate** |
| **E. faecalis (+)** | | | | | | |
| **Day1** | 4.0 | 4.0 | 0.0 | 3.0 | 3.0 | 0.0 |
| | 4.0 | 4.5 | 0.0 | 4.0 | 2.0 | 0.0 |
| | 3.0 | 4.5 | 0.0 | 3.0 | 2.0 | 0.0 |
| **Day2** | 2.0 | 3.0 | 0.0 | 0.0 | 0.0 | 0.0 |
| | 3.0 | 1.5 | 0.0 | 0.0 | 0.0 | 0.0 |
| | 2.0 | 3.0 | 0.0 | 0.0 | 0.0 | 0.0 |
| **Day3** | 1.0 | 0.5 | 0.0 | 0.0 | 0.0 | 0.0 |
| | 1.0 | 0.5 | 0.0 | 0.0 | 0.0 | 0.0 |
| | 0.5 | 1.0 | 0.0 | 0.0 | 0.0 | 0.0 |
| **S. epidermis (+)** | | | | | | |
| **Day1** | 10.0 | 10.0 | 0.0 | 9.0 | 8.0 | 0.0 |
| | 11.0 | 10.0 | 0.0 | 12.0 | 6.0 | 0.0 |
| | 9.0 | 10.0 | 0.0 | 10.0 | 12.0 | 0.0 |
| **Day2** | 7.0 | 3.5 | 0.0 | 0.0 | 0.5 | 0.0 |
| | 7.0 | 3.5 | 0.0 | 1.0 | 0.0 | 0.0 |
| | 5.0 | 2.5 | 0.0 | 0.0 | 0.0 | 0.0 |
| **Day3** | 6.0 | 6.0 | 0.0 | 0.0 | 0.5 | 0.0 |
| | 4.5 | 5.0 | 0.0 | 0.0 | 0.0 | 0.0 |
| | 5.0 | 5.0 | 0.0 | 1.0 | 0.0 | 0.0 |
| **Day4** | 1.0 | 2.0 | 0.0 | 0.0 | 0.0 | 0.0 |
| | 4.0 | 2.0 | 0.0 | 0.0 | 0.0 | 0.0 |
| | 2.0 | 1.0 | 0.0 | 0.0 | 0.0 | 0.0 |
| **E. Coli (-)** | | | | | | |
| **Day1** | 5.0 | 6.0 | 0.0 | 5.0 | 6.0 | 0.0 |
| | 7.0 | 6.0 | 0.0 | 8.0 | 4.0 | 0.0 |
| | 1.0 | 5.0 | 0.0 | 10.0 | 9.0 | 0.0 |
| **Day2** | 3.0 | 2.5 | 0.0 | 0.0 | 1.0 | 0.0 |
| | 4.0 | 2.5 | 0.0 | 1.0 | 0.0 | 0.0 |
| | 2.0 | 1.0 | 0.0 | 3.0 | 2.5 | 0.0 |
| **Day3** | 2.0 | 2.0 | 0.0 | 0.0 | 0.0 | 0.0 |
| | 3.0 | 2.5 | 0.0 | 0.0 | 0.0 | 0.0 |
| | 2.0 | 2.0 | 0.0 | 1.0 | 0.5 | 0.0 |
| **Day4** | 1.0 | 0.0 | 0.0 | 0.0 | 0.0 | 0.0 |
| | 1.0 | 0.5 | 0.0 | 0.0 | 0.0 | 0.0 |
| | 0.0 | 1.0 | 0.0 | 0.0 | 0.0 | 0.0 |
| **K. pneumoniae (-)** | | | | | | |
| **Day1** | 3.0 | 4.0 | 0.0 | 2.0 | 2.0 | 0.0 |
| | 3.0 | 2.5 | 0.0 | 4.0 | 3.0 | 0.0 |
| | 2.0 | 3.0 | 0.0 | 2.0 | 3.0 | 0.0 |
| **Day2** | 2.0 | 3.0 | 0.0 | 0.0 | 0.0 | 0.0 |
| | 1.0 | 1.5 | 0.0 | 1.0 | 0.0 | 0.0 |
| | 1.0 | 0.5 | 0.0 | 0.0 | 0.0 | 0.0 |
| **Day3** | 0.0 | 0.0 | 0.0 | 0.0 | 0.0 | 0.0 |
| | 1.0 | 0.5 | 0.0 | 0.0 | 0.0 | 0.0 |
| | 0.0 | 0.0 | 0.0 | 0.0 | 0.0 | 0.0 |
| **P. aerugosia (-)** | | | | | | |
| **Day1** | 10.0 | 12.0 | 0.0 | 6.0 | 6.0 | 0.0 |
| | 12.0 | 12.0 | 0.0 | 7.0 | 6.5 | 0.0 |
| | 10.0 | 10.0 | 0.0 | 5.0 | 6.5 | 0.0 |
| **Day2** | 4.0 | 3.0 | 0.0 | 1.0 | 0.5 | 0.0 |
| | 4.0 | 2.5 | 0.0 | 3.0 | 2.5 | 0.0 |
| | 4.0 | 1.0 | 0.0 | 3.0 | 0.5 | 0.0 |
| **Day3** | 2.0 | 3.0 | 0.0 | 0.0 | 0.0 | 0.0 |
| | 1.5 | 1.0 | 0.0 | 0.0 | 0.0 | 0.0 |
| | 3.0 | 1.5 | 0.0 | 0.0 | 0.0 | 0.0 |
| **S. aureus MR (+)** | | | | | | |
| **Day1** | 12.0 | 14.0 | 0.0 | 6.0 | 7.0 | 0.0 |
| | 13.0 | 12.5 | 0.0 | 4.0 | 7.0 | 0.0 |
| | 12.0 | 10.0 | 0.0 | 12.0 | 10.0 | 0.0 |
| **Day2** | 9.0 | 8.0 | 0.0 | 2.0 | 2.0 | 0.0 |
| | 7.0 | 7.5 | 0.0 | 4.0 | 2.0 | 0.0 |
| | 10.0 | 7.0 | 0.0 | 2.0 | 4.0 | 0.0 |
| **Day3** | 4.0 | 5.0 | 0.0 | 1.0 | 0.0 | 0.0 |
| | 5.0 | 4.5 | 0.0 | 4.0 | 1.0 | 0.0 |
| | 6.0 | 8.0 | 0.0 | 0.0 | 0.0 | 0.0 |
| **Day4** | 1.0 | 2.5 | 0.0 | 0.0 | 0.0 | 0.0 |
| | 2.0 | 3.0 | 0.0 | 0.0 | 0.0 | 0.0 |
| | 1.0 | 0.5 | 0.0 | 0.0 | 0.0 | 0.0 |

EXAMPLE 9-**Arc Control**

This example demonstrates how arc control is directly related to the size and frequency of macro-particles produced. In this example, two sample runs were preformed The first, sample three, had no arc control and the substrate was placed at a distance of 30.48 cm (12 inches) from the target. The second, sample four, had arc control and the substrate was also placed at a distance of 30.48 cm (12 inches) from the target. Both samples were placed in the chamber, at separate times for separate runs, and pumped to 0.066661 Pa (5E-4 Torr). The arc was set at 100 Amps for all power supplies to begin with. Each target had two supplies for a starting total of 200 amps. Sample three was run for five minutes with no arc control. Sample four was run with an optimized switching of current at a rate of 300 hertz.

The switching always kept 200 amps on the target, but each power supply was ramped up and down so at any time, the current was not equal on the supplies. This forced the arc to travel a specific distance in a specific time, thereby controlling the macro-particle density and size.

SEM cross sectional analysis was performed on samples three and four. It was observed that, while the films were consistent throughout the entire thickness, sample four had a much larger average of macro-particle size and density then did sample three. The average size of the macro-particles in sample three was approximately one micron with a density of 10³ / cm². The average size of macro-particles in sample four was approximately three microns with a density of 10⁴ / cm².

EXAMPLE 10 *- in vitro* Testing of AgO on Metals

This example demonstrates the effectiveness of the AgO coating on Ti-6-4 and CoCrMo. Samples five and six were cleaned using usual procedures and placed in the vacuum chamber at a distance of 30.48 cm (12 inches) from the target. The typical silver oxide coating was deposited on the pieces and ZOI testing was done for three days. Sample five was Ti-6-4 and sample six was CoCrMo. Results are summarized in Table 13.

**TABLE 13**

| **Day1** | | | | | | |
|---|---|---|---|---|---|---|
| | **Substrate** | **5** | | **Substrate** | **6** | |
| | **Plate 1 ZOI (mm)** | **Plate 2 ZOI (mm)** | **Control Plate** | **Plate 1 ZOI (mm)** | **Plate 2 ZOI (mm)** | **Control Plate** |
| **S. epidermis (+)** | | | | | | |
| **Day1** | 12.0 | 10.0 | 0.0 | 10.0 | 11.0 | 0.0 |
| | 12.0 | 9.5 | 0.0 | 11.0 | 12.0 | 0.0 |
| | | 14.5 | 0.0 | 11.0 | 9.0 | 0.0 |
| **Day2** | 8.0 | 8.5 | 0.0 | 8.0 | 8.0 | 0.0 |
| | 8.0 | 8.5 | 0.0 | 8.0 | 8.5 | 0.0 |
| | 6.0 | 2.5 | 0.0 | 8.0 | 8.0 | 0.0 |
| **Day3** | 5.0 | 6.0 | 0.0 | 5.0 | 4.0 | 0.0 |
| | 4.5 | 3.5 | 0.0 | 6.0 | 7.0 | 0.0 |
| | 4.0 | 3.0 | 0.0 | 6.0 | 4.5 | 0.0 |
| **E. Coli (-)** | | | | | | |
| **Day1** | 5.0 | 2.5 | 0.0 | 5.0 | 2.5 | 0.0 |
| | 7.0 | 3.5 | 0.0 | 8.0 | 4.0 | 0.0 |
| | 1.0 | 0.5 | 0.0 | 10.0 | 5.0 | 0.0 |
| **Day2** | 3.0 | 1.5 | 0.0 | 0.0 | 0.0 | 0.0 |
| | 4.0 | 2.0 | 0.0 | 1.0 | 0.5 | 0.0 |
| | 2.0 | 1.0 | 0.0 | 3.0 | 1.5 | 0.0 |
| **Day3** | 2.0 | 1.0 | 0.0 | 0.0 | 0.0 | 0.0 |
| | 3.0 | 1.5 | 0.0 | 0.0 | 0.0 | 0.0 |
| | 2.0 | 1.0 | 0.0 | 1.0 | 0.5 | 0.0 |
| **S. aureus MR (+)** | | | | | | |
| **Day1** | 12.0 | 16.0 | 0.0 | 16.0 | 12.0 | 0.0 |
| | 13.0 | 12.5 | 0.0 | 14.0 | 12.0 | 0.0 |
| | 12.0 | 11.0 | 0.0 | 12.0 | 9.0 | 0.0 |
| **Day2** | 10.0 | 14.0 | 0.0 | 10.0 | 9.0 | 0.0 |
| | 9.0 | 10.0 | 0.0 | 9.0 | 10.0 | 0.0 |
| | 11.0 | 10.0 | 0.0 | 9.0 | 5.0 | 0.0 |
| **Day3** | 3.0 | 6.0 | 0.0 | 5.0 | 7.5 | 0.0 |
| | 6.0 | 6.5 | 0.0 | 4.0 | 8.0 | 0.0 |
| | 5.0 | 5.0 | 0.0 | 3.0 | 0.0 | 0.0 |

## Claims

1. A cathodic arc ion plasma deposition method for producing an anti-microbial metal/metal oxide coating on a substrate, comprising positioning a selected substrate between an anode and a cathode target, said target comprising an ionizable metal, introducing oxygen gas into a vacuum chamber which houses the cathode target and the substrate, wherein the chamber is pressurized to 0.0133322 Pa (0.1 mTorr) to 3.99966 Pa (30 mTorr), and producing an arc discharge between the anode and the cathode target wherein arc speed is optionally variably controlled to produce particles in the range of 1 nm to 50 microns; **characterized in that** the movement of the substrate toward or away from the target is adjusted within a range of 2.54 cm (1 inch) to 127 cm (50 inches) for a predetermined time at a temperature of between 25°C and 75°C during arc discharge to deposit a high density, adherent anti-microbial coating having a thickness of 50 nm to 5 microns on the substrate.

2. The method of claim 1 wherein power to the arc is externally controlled by a single variable power supply or by at least two independently variable power supplies attached in opposed positions to the cathode target.

3. The method of claim 2 wherein power to the arc is adjusted to 12 to 60 volts providing between 5 and 500 amps during deposition of a 100-200 nm coating on the substrate.

4. The method of claim 1 wherein the ionizable metal is a metal selected from the group consisting of silver, gold, platinum, copper, tantalum, titanium, zirconium, hafnium, and zinc.

5. The method of claim 1 wherein the substrate comprises a polymer or ceramic.

6. The method of claim 5 wherein the polymer is PEEK or polyethylene.

7. A highly adherent Ag/AgO anti-microbial film deposited by the method of claim 1 on a metal or polymer substrate wherein the arc speed is controlled so that the Ag/AgO impregnates the metal substrate up to a depth of 10 nm or impregnates the polymer substrate up to a depth of 100 nm.

8. The Ag/AgO anti-microbial film of claim 7 wherein the metal substrate is titanium, steel, chromium, zirconium, nickel, combinations and alloys thereof.

9. The Ag/AgO anti-microbial film of claim 7 wherein the polymer substrate is polypropylene, polyurethane, EPTFE, PTFE, polyimide, polyester, PEEK, UHMWPE, or nylon and combinations thereof.

10. The method of claim 1 further comprising monitoring the amount of silver deposited in the film in relation to the distance of the substrate from the target, wherein increased antimicrobial activity of the film correlates with a decrease in the silver/ silver oxide ratio in the film.

11. The method of claim 10 further comprising adjusting arc speed and monitoring particle size of deposited silver/silver oxide wherein an increase in number of macro particles increases antimicrobial activity of the film.

12. A medical device coated with an antimicrobial Ag/AgO film produced by the method of claim 1.

13. The medical device of claim 12 comprising a mesh substrate coated with an antimicrobial Ag/AgO film produced by the method of claim 1.

14. The device of claim 13 wherein the mesh substrate is a mesh sack coated with said antimicrobial film.

15. The device of claim 13 wherein the mesh substrate is a metal, polymer or ceramic.

16. The device of claim 14 wherein the mesh sack comprises a biodegradable polymer on which the antimicrobial film is deposited.

## Patentansprüche

1. Kathodisches Ionenbogen-Plasma-Niederschlags-Verfahren zur Herstellung einer anti-mikrobiellen Metall/Metalloxid Beschichtung auf einem Substrat, umfassend:
Positionierung eines ausgewählten Substrats zwischen einer Anode und einem Kathoden-Target, wobei besagtes Target ein ionisierbares Metall umfasst,
Einführung von Sauerstoffgas in eine Vakuumkammer, welche das Kathoden-Target und das Substrat beinhaltet, wobei die Kammer unter einem Druck von 0,0133322 PA (0,1 mTorr) bis 3,99966 Pa (30 mTorr) steht, und
Auslösen einer Bogen-Entladung zwischen der Anode und dem Kathoden-Target, wobei optional die Geschwindigkeit des Bogens variable gesteuert ist, um Partikel im Bereich von 1 nm bis 50 µm zu erzeugen;
**dadurch gekennzeichnet, dass** die Bewegung des Substrats in Richtung zum Target oder weg vom Target in einem Bereich von 2,54 cm (1 inch) bis 127 cm (50 inch) für eine vorher festgelegte Zeit bei einer Temperatur zwischen 25°C und 75°C während der Bogen-Entladung eingestellt ist, um eine hochdichte, anhaftende anti-mikrobiellen Beschichtung, die eine Dicke von 50 nm bis 5 µm auf dem Substrat aufweist, aufzutragen.

2. Verfahren nach Anspruch 1, wobei die Stromzufuhr zum Bogen extern durch eine einzelne variable Stromquelle oder durch mindestens zwei unabhängig variable Stromquellen, die in gegenüberliegenden Positionen am Kathoden-Target angebracht sind, gesteuert wird.

3. Verfahren nach Anspruch 2, wobei die Stromzufuhr zum Bogen auf 12 bis 60 Volt eingestellt ist, welches, während einer Ablagerung einer 100 - 200 nm Beschichtung auf dem Substrat, zwischen 5 und 500 amp zur Verfügung stellt.

4. Verfahren nach Anspruch 1, wobei das ionisierbare Metall ein Metall ist, ausgewählt aus der Gruppe, bestehend aus Silber, Gold, Platin, Kupfer, Tantal, Titan, Zirkon, Hafnium, und Zink.

5. Verfahren nach Anspruch 1, wobei das Substrat ein Polymer oder Keramik umfasst.

6. Verfahren nach Anspruch 5, wobei das Polymer PEEK oder Polyethylen ist.

7. Stark anhaftender anti-mikrobieller Ag/AgO Film, der nach dem Verfahren nach Anspruch 1 auf ein Metall oder Polymer Substrat aufgebracht ist, wobei die Geschwindigkeit des Bogens so gesteuert ist, dass das Ag/AgO das Metal Substrat bis zu einer Tiefe von 10 nm oder das Polymer Substrat bis zu einer Tiefe von 100 nm imprägniert.

8. Anti-mikrobieller Ag/AgO Film nach Anspruch 7, wobei das Metall Substrat Titan, Stahl, Chrom, Zirkon, Nickel, und Kombinationen und Legierungen derselben ist.

9. Anti-mikrobieller Ag/AgO Film nach Anspruch 7, wobei das Polymer Substrat Polypropylen, Polyurethan, EPTFE, PTFE, Polyimid, Polyester, PEEK, UHMWPE, oder Nylon und Kombinationen derselben ist.

10. Verfahren nach Anspruch 1, welches zusätzlich die Überwachung der im Film abgelagerten Silbermenge im Verhältnis zur Distanz des Substarts zum Target umfasst, wobei eine zunehmende anti-mikrobielle Aktivität des Film mit einer Abnahmen des Silber/Silberoxid-Verhältnisses im Film korreliert.

11. Verfahren nach Anspruch 10, welches zusätzlich die Einstellung der Bogen-Geschwindigkeit und die Überwachung der Partikel-Größe des abgelagerten Silbers/Silberoxids umfasst, wobei eine Zunahme der Anzahl an Makro-Partikeln die anti-mikrobielle Aktivität des Films erhöht.

12. Medizinprodukt beschichtet mit einem anti-mikrobielle Ag/AgO Film, welcher nach dem Verfahren nach Anspruch 1 hergestellt wurde.

13. Medizinprodukt nach Anspruch 12, welches ein Gewebe Substrat umfasst, das mit einem anti-mikrobielle Ag/AgO Film beschichtetet ist, welcher nach dem Verfahren nach Anspruch 1 hergestellt wurde.

14. Medizinprodukt nach Anspruch 13, wobei das Gewebe Substrat ein Gewebe-Beutel ist, welcher mit besagtem anti-mikrobiellen Film beschichtet ist.

15. Medizinprodukt nach Anspruch 13, wobei das Gewebe Substrat ein Metall, Polymer oder Keramik ist.

16. Medizinprodukt nach Anspruch 14, wobei der Gewebe-Beutel ein biologisch abbaubares Polymer umfasst, auf welchem der anti-mikrobielle Film aufgetragen ist.

## Revendications

1. Procédé pour le dépôt cathodique de plasma d'ions par arc pour la production d'un revêtement de métal/oxyde métallique antimicrobien sur un substrat, comprenant le positionnement d'un substrat sélectionné entre une anode et une cathode cible, ladite cible comprenant un métal ionisable, l'introduction de gaz oxygène dans une chambre à vide qui héberge la cathode cible et le substrat, tandis que la chambre est mise sous une pression de 0,0133322 Pa (0,1 mTorr) à 3,99966 Pa (30 mTorr), et la production d'une décharge d'arc entre l'anode et la cathode cible, la vitesse de l'arc étant en option réglée de manière variable pour produire des particules dans l'intervalle de 1 nm à 50 micromètres, **caractérisé en ce que** le mouvement du substrat vers ou depuis la cible est ajusté dans un intervalle de 2,54 cm (1 pouce) à 127 cm (50 pouces) pendant une durée prédéterminée à une température se situant entre 25°C et 75°C pendant la décharge de l'arc pour le dépôt d'un revêtement antimicrobien adhérent de densité élevée, ayant une épaisseur de 50 nm à 5 micromètres sur le substrat.

2. Procédé selon la revendication 1, dans lequel l'énergie à l'arc est réglée de manière externe par une unique alimentation en énergie variable ou par au moins deux alimentations en énergie, variables indépendamment, fixées dans des positions opposées par rapport à la cathode cible.

3. Procédé selon la revendication 2, dans lequel la puissance à l'arc est ajustée entre 12 et 60 volts, procurant entre 5 et 500 ampères pendant le dépôt d'un revêtement de 100-200 nm sur le substrat.

4. Procédé selon la revendication 1, dans lequel le métal ionisable est un métal choisi dans le groupe consistant en argent, or, platine, cuivre, tantale, titane, zirconium, hafnium, et zinc.

5. Procédé selon la revendication 1, dans lequel le substrat comprend un polymère ou une céramique.

6. Procédé selon la revendication 5, dans lequel le polymère est de la PEEK ou du polyéthylène.

7. Film antimicrobien de Ag/AgO fortement adhérent, déposé par le procédé selon la revendication 1 sur un substrat en métal ou en polymère, dans lequel la vitesse de l'arc est pilotée de telle manière que le Ag/AgO imprègne le substrat en métal jusqu'à une profondeur de 10 nm ou imprègne le substrat en polymère jusqu'à une profondeur de 100 nm.

8. Film antimicrobien de Ag/AgO selon la revendication 7, dans lequel le substrat en métal est du titane, de l'acier, du chrome, du zirconium, du nickel, ou leurs combinaisons et alliages.

9. Film antimicrobien de Ag/AgO selon la revendication 7, dans lequel le substrat en polymère est du polypropylène, du polyuréthanne, du EPTFE, du PTFE, du polyimide, du polyester, de la PEEK, du UHMWPE, ou un nylon et leurs combinaisons.

10. Procédé selon la revendication 1, comprenant en outre le pilotage de la quantité d'argent déposée dans le film en fonction de la distance entre le substrat et la cible, tandis qu'une activité antimicrobienne accrue du film est en corrélation avec une diminution du rapport d'argent/oxyde d'argent dans le film.

11. Procédé selon la revendication 10, comprenant en outre l'ajustement de la vitesse de l'arc et le pilotage de la taille des particules d'argent/oxyde d'argent déposé, tandis qu'une augmentation du nombre des macroparticules accroît l'activité antimicrobienne du film.

12. Dispositif médical revêtu d'un film d'Ag/AgO antimicrobien produit par le procédé selon la revendication 1.

13. Dispositif médical selon la revendication 12, comprenant un substrat formant crible revêtu d'un film d'Ag/AgO antimicrobien produit par le procédé selon la revendication 1.

14. Dispositif selon la revendication 13, dans lequel le substrat formant crible est un sac formant crible revêtu dudit film antimicrobien.

15. Dispositif selon la revendication 13, dans lequel le substrat formant crible est un métal, un polymère ou une céramique.

16. Dispositif selon la revendication 14, dans lequel le sac formant crible comprend un polymère biodégradable sur lequel le film antimicrobien est déposé.
